# DEMANDE DE BREVET EUROPEEN

(11) **EP 4 597 127 A1**
(43) Date de publication de la demande: **06.08.2025**
(21) Numéro de dépôt: 25155468.9
(22) Date de dépôt: 03.02.2025
(51) Int. Cl.: G01R 31/26, G01R 31/28, G01R 31/40

(54) **CIRCUIT ADAPTE POUR LA MISE EN OEUVRE DE TEST SOUS CONTRAINTE DE GRILLES DE TRANSISTORS DE PUISSANCE**

(30) Priorité: 05.02.2024 FR 2401084
(71) Demandeur: STMicroelectronics International N.V., 1228 Plan-les-Ouates, Geneva (CH)
(72) Inventeur: LENZ, Kuno, 38340 VOREPPE (FR); SIRITO-OLIVIER, Philippe, 13500 MARTIGUES (FR); DELSALLE, David, 38000 GRENOBLE (FR)
(74) Mandataire: Cabinet Beaumont

(57) **Abrégé**

La présente description concerne un circuit électronique de puissance (100) comprenant au moins un transistor de puissance (102, 106) dont la grille est couplée à un circuit de commande (104, 108) et dont la source est couplée à un premier plot de contact (114, 124), dans lequel le circuit de commande (104, 108) est couplé à un deuxième plot de contact (116, 126), et dans lequel les premier et deuxième plots de contact (114, 116, 124, 126) sont configurés pour être découplés l'un de l'autre lorsque le circuit électronique de puissance (100) est dans une configuration de test sous contrainte de la grille du transistor de puissance (102, 106) et configurés pour être couplés l'un à l'autre lorsque le transistor de puissance (102, 106) et le circuit de commande (104, 108) sont encapsulés.

## Description

### Domaine technique

La présente description concerne de façon générale le domaine des circuits électroniques de puissance comprenant des transistors de puissance, en particulier celui des convertisseurs DC-DC, ou convertisseur continu - continu.

### Technique antérieure

Lors de la production de circuits de puissance tels que des convertisseurs DC-DC, les transistors de puissance de ces circuits (par exemple formant les cellules de commutation dans le cas d'un convertisseur) sont testés afin d'écarter les circuits comprenant des transistors non conformes aux spécifications requises et utiliser ceux comprenant des transistors conformes à ces spécifications. Un de ces tests, appelé test sous contrainte de grille, consiste à appliquer une forte tension, appelée tension de contrainte, entre la grille et la source du transistor de puissance soumis à ce test. Par exemple, cette tension de contrainte peut être égale à 11 V et peut être appliquée pendant une durée de 200 ms. Pour un transistor PMOS, la tension de contrainte appliquée entre la grille et la source du transistor est négative pour éviter des dégradations de type PBTI (« positive bias température instabilities » en anglais, ou instabilité de température de polarisation positive).

Cette tension de contrainte est bien supérieure à la tension nominale d'alimentation, par exemple de 5V ou 7V, appliquée lors d'une utilisation « classique » en commutation, ou en fonctionnement, de ces transistors. Ce test sous contrainte des grilles des transistors de puissance permet d'identifier la présence de défauts dans les transistors testés, par exemple dans leur oxyde de grille, pouvant engendrer des courants de fuite importants après peu de temps d'utilisation des transistors (par exemple après environ un an). Les fuites dans les transistors présentant de tels défauts apparaissent donc lors du test sous contrainte et les circuits de puissance comprenant ces transistors défectueux peuvent ainsi être identifiés et écartés sans attendre l'apparition de telles fuites lors de leur utilisation.

Durant les tests sous contrainte, les autres composants du circuit couplés aux connexions sur lesquelles les tensions de contrainte sont appliquées, notamment les composants des circuits de commande des transistors de puissance, sont protégés pour qu'ils ne soient pas détruits par les tensions de contrainte. Par exemple, dans le cas d'un circuit de commutation comprenant un inverseur CMOS, cette protection peut être obtenue en ajoutant un transistor additionnel couplé à une résistance électrique en sortie de l'inverseur.

En outre, des plots de contact internes dédiés sont utilisés durant les tests sous contrainte des transistors pour mesurer les courants de fuite, ainsi que pour l'application de la tension de contrainte pour les transistors de puissance du côté bas, ou « low-side », du circuit.

Enfin, du fait que les drains des transistors de puissance du côté bas et du côté haut (« high-side ») du circuit sont couplés à un même plot de contact sur lequel le signal de sortie des transistors de puissance est récupéré, il n'est pas possible de tester simultanément les transistors de puissance du côté haut et ceux du côté bas du circuit de puissance.

### Résumé de l'invention

Il existe un besoin de proposer une solution ne présentant pas au moins une partie des inconvénients des solutions existantes.

Un mode de réalisation pallie tout ou partie des inconvénients des solutions connues et propose un circuit électronique de puissance comprenant au moins un transistor de puissance dont la grille est couplée à un circuit de commande et dont la source est couplée à un premier plot de contact, dans lequel le circuit de commande est couplé à un deuxième plot de contact, et dans lequel les premier et deuxième plots de contact sont configurés pour être découplés l'un de l'autre lorsque le circuit électronique de puissance est dans une configuration de test sous contrainte de la grille du transistor de puissance et configurés pour être couplés l'un à l'autre lorsque le transistor de puissance et le circuit de commande sont encapsulés.

Selon un mode de réalisation, le transistor de puissance et le circuit de commande sont des composants côté haut du circuit électronique de puissance, et les premier et deuxième plots de contact sont configurés pour que des potentiels électriques d'alimentation différents soient appliqués sur chacun d'eux lorsque le circuit électronique de puissance est dans la configuration de test sous contrainte de la grille du transistor de puissance.

Selon un mode de réalisation, le transistor de puissance et le circuit de commande sont des composants côté bas du circuit électronique de puissance, et les premier et deuxième plots de contact sont configurés pour que des potentiels électriques de référence différents soient appliqués sur chacun d'eux lorsque le circuit électronique de puissance est dans la configuration de test sous contrainte de la grille du transistor de puissance.

Selon un mode de réalisation :
- le transistor de puissance, appelé premier transistor de puissance, et le circuit de commande, appelé premier circuit de commande, sont des composants côté haut du circuit électronique de puissance, et
- le circuit électronique de puissance comporte en outre un deuxième transistor de puissance dont la grille est couplée à un deuxième circuit de commande et dont la source est couplée à un troisième plot de contact, le deuxième circuit de commande étant couplé à un quatrième plot de contact, le deuxième transistor de puissance et le deuxième circuit de commande correspondant à des composants côté bas du circuit électronique de puissance, et
- les premier et deuxième plots de contact sont configurés pour que des potentiels électriques d'alimentation différents soient appliqués sur chacun d'eux lorsque le circuit électronique de puissance est dans une configuration de test sous contrainte des grilles des premier et deuxième transistors de puissance, et
- les troisième et quatrième plots de contact sont configurés pour être découplés l'un de l'autre et pour que des potentiels électriques de référence différents soient appliqués sur chacun d'eux lorsque le circuit électronique de puissance est dans la configuration de test sous contrainte des grilles des premier et deuxième transistors de puissance, et configurés pour être couplés l'un à l'autre lorsque les premier et deuxième transistors de puissance et les premier et deuxième circuits de commande sont encapsulés.

Selon un mode de réalisation, le drain du premier transistor de puissance est couplé à un premier plot de commutation et le drain du deuxième transistor de puissance est couplé à un deuxième plot de commutation, et les premier et deuxième plots de commutation sont configurés pour être découplés l'un de l'autre lorsque le circuit électronique de puissance est dans la configuration de test sous contrainte des grilles des premier et deuxième transistors de puissance et configurés pour être couplés l'un à l'autre lorsque les premier et deuxième transistors de puissance et les premier et deuxième circuits de commande sont encapsulés.

Selon un mode de réalisation, le circuit de commande, ou chacun des premier et deuxième circuits de commande, comporte un inverseur CMOS dont la sortie est couplée à la grille du transistor de puissance ou d'un des premier et deuxième transistors de puissance, et/ou le transistor de puissance, ou chacun des premier et deuxième transistors de puissance, correspond à un MOSFET.

Selon un mode de réalisation, le circuit électronique de puissance inclut un élément d'encapsulation.

Selon un mode de réalisation, le circuit électronique de puissance comporte en outre un premier connecteur électrique couplant électriquement entre eux les premier et deuxième plots de contact, et, lorsque le circuit électronique de puissance comporte des troisième et quatrième plots de contact, un deuxième connecteur électrique couplant entre eux les troisième et quatrième plots de contact

Selon un mode de réalisation, le circuit électronique de puissance comporte les premier et deuxième plots de commutation et un troisième connecteur électrique couplant entre eux les premier et deuxième plots de commutation.

Selon un mode de réalisation, le circuit électronique de puissance correspond à un convertisseur DC-DC.

Il est également proposé un procédé de réalisation et d'encapsulation d'au moins un circuit électronique de puissance, comportant au moins les étapes suivantes :
- réalisation du circuit électronique de puissance tel que précédemment décrit ;
- mise en oeuvre d'un test sous contrainte de la ou des grilles du ou des transistors de puissance du circuit électronique de puissance ;
- encapsulation du ou des transistors de puissance et du ou des circuits de commande du circuit électronique de puissance.

Selon un mode de réalisation, le test sous contrainte de la ou des grilles du ou des transistors de puissance comporte une mesure d'un courant de fuite sur le premier plot de contact et/ou sur le troisième plot de contact.

Selon un mode de réalisation, l'encapsulation du ou des transistors de puissance et du ou des circuits de commande comporte une réalisation d'un premier connecteur électrique couplant électriquement entre eux les premier et deuxième plots de contact du circuit électronique de puissance, et, lorsque le circuit électronique de puissance comporte des troisième et quatrième plots de contact, une réalisation d'un deuxième connecteur électrique couplant entre eux les troisième et quatrième plots de contact du circuit électronique de puissance.

Selon un mode de réalisation, l'encapsulation du ou des transistors de puissance et du ou des circuits de commande comporte en outre une réalisation d'un troisième connecteur électrique couplant entre eux les premier et deuxième plots de commutation du circuit électronique de puissance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
- la figure 1 représente schématiquement un exemple d'une partie d'un circuit électronique de puissance selon un mode de réalisation particulier, dans une configuration de test sous contrainte des grilles des transistors de puissance du circuit ;
- la figure 2 représente schématiquement un exemple d'une partie d'un circuit électronique de puissance selon un mode de réalisation particulier, après une interconnexion des plots de contact du circuit ;
- la figure 3 représente schématiquement un circuit électronique de puissance dont les composants sont encapsulés, selon un mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, différents éléments et composants du circuit électronique de puissance ne sont pas détaillés. L'homme du métier sera capable de réaliser de manière détaillée ces éléments à partir de la description donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais "coupled") entre eux, cela signifie que ces deux éléments peuvent être connectés ou être reliés par l'intermédiaire d'un ou plusieurs autres éléments. De plus, le terme « couplé » est utilisé ici pour désigner un couplage électrique entre plusieurs éléments (composants, circuits, etc.) électriques et/ou électroniques. Il en est de même pour le terme « découplé ».

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures dans une position normale d'utilisation.

Sauf précision contraire, les expressions "environ", "approximativement", "sensiblement", et "de l'ordre de" signifient à 10 % près, de préférence à 5 % près.

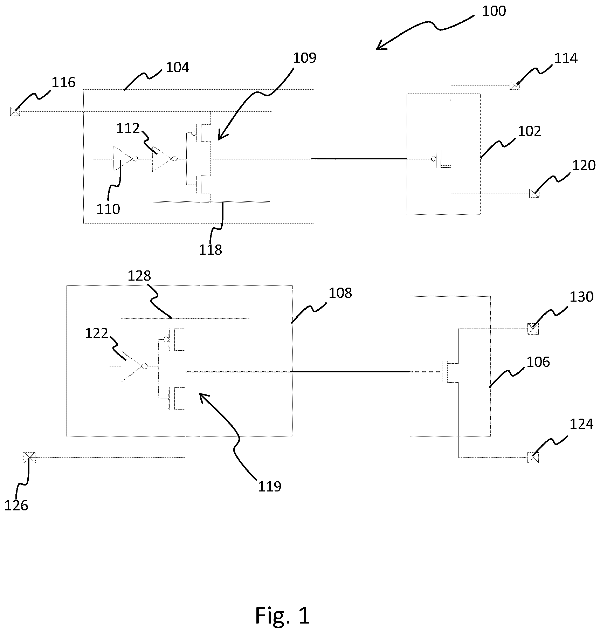

Un circuit électronique de puissance 100 selon un mode de réalisation particulier est décrit ci-dessous en lien avec la figure 1. Une partie seulement des éléments et composants du circuit 100 sont décrits ci-dessous et visibles sur la figure 1.

Le circuit 100 comporte des éléments ou composants électriques et/ou électroniques d'une partie côté haut, ou « high-side », du circuit 100, sur lesquels au moins un potentiel électrique d'alimentation du circuit 100 est destiné à être appliqué. Le circuit 100 comporte également des éléments ou composants électriques et/ou électroniques d'une partie côté bas, ou « low-side », du circuit 100, sur lesquels au moins un potentiel électrique de référence, servant par exemple de masse, du circuit 100 est destiné à être appliqué.

Dans l'exemple de réalisation décrit, le circuit 100 comporte un ou plusieurs premiers transistors de puissance 102, ainsi qu'un ou plusieurs premiers circuits de commande 104 faisant partie du côté haut du circuit 100. Les premiers circuits de commande 104 sont configurés pour commander la commutation des premiers transistors de puissance 102. Lorsque le circuit 100 comporte plusieurs premiers transistors de puissance 102, la grille de chacun de ces premiers transistors de puissance 102 est couplée à la sortie d'un premier circuit de commande 104 dédié à la commande de ce transistor.

Le circuit 100 comporte également un ou plusieurs deuxièmes transistors de puissance 106, et un ou plusieurs deuxièmes circuits de commande 108 faisant partie du côté bas du circuit 100. Les deuxièmes circuits de commande 108 sont configurés pour commander la commutation des deuxièmes transistors de puissance 106. Lorsque le circuit 100 comporte plusieurs deuxièmes transistors de puissance 106, la grille de chacun de ces deuxièmes transistors de puissance 106 est couplée à la sortie d'un deuxième circuit de commande 108 dédié à la commande de ce transistor.

Sur la figure 1, un seul premier transistor de puissance 102, un seul premier circuit de commande 104, un seul deuxième transistor de puissance 106 et un seul deuxième circuit de commande 108 sont représentés. Les caractéristiques décrites ci-dessous pour chacun de ces composants peuvent s'appliquer également aux autres transistors de puissance et circuits de commande du circuit 100 non représentés sur la figure 1.

Dans l'exemple de réalisation décrit, les transistors de puissance 102, 106 et les transistors des circuits de commande 104, 108 correspondent à des MOSFET. En variante, d'autres types de transistors peuvent servir à former les transistors de puissance 102, 106 et/ou les transistors des circuits de commande 104, 108.

Sur l'exemple de la figure 1, le premier transistor de puissance 102 correspond à un transistor PMOS dont la grille est couplée au premier circuit de commande 104. Plus particulièrement, dans l'exemple de réalisation décrit, la grille du premier transistor de puissance 102 est couplée à la sortie d'un premier inverseur CMOS 109 du premier circuit de commande 104 (cette sortie étant couplée aux drains des transistors NMOS et PMOS du premier inverseur CMOS 109). Sur l'exemple de la figure 1, l'entrée du premier inverseur CMOS 109 (qui est couplée aux grilles des transistors NMOS et PMOS du premier inverseur CMOS 109) est couplée à deux inverseurs 110, 112 couplés en série l'un à l'autre.

La source du premier transistor de puissance 102 est couplée à un premier plot de contact 114, et le premier circuit de commande 104 est couplé à un deuxième plot de contact 116. Sur l'exemple de la figure 1, c'est la source du transistor PMOS du premier inverseur CMOS 109 qui est couplée au deuxième plot de contact 116. Dans cet exemple, la source du transistor NMOS du premier inverseur CMOS 109 est couplée à une masse flottante 118. Enfin, le drain du premier transistor de puissance 102 est couplé à un autre plot de contact appelé premier plot de commutation 120.

Sur l'exemple de la figure 1, le deuxième transistor de puissance 106 correspond à un transistor NMOS dont la grille est couplée au deuxième circuit de commande 108. Plus particulièrement, dans l'exemple de réalisation décrit, la grille du deuxième transistor de puissance 106 est couplée à la sortie d'un deuxième inverseur CMOS 119 du deuxième circuit de commande 108 (cette sortie étant couplée aux drains des transistors NMOS et PMOS du deuxième inverseur CMOS 119). Sur l'exemple de la figure 1, l'entrée du deuxième inverseur CMOS 119 (qui est couplée aux grilles des transistors NMOS et PMOS du deuxième inverseur CMOS 119) est couplée à un inverseur 122.

La source du deuxième transistor de puissance 106 est couplée à un troisième plot de contact 124, et le deuxième circuit de commande 108 est couplé à un quatrième plot de contact 126. Sur l'exemple de la figure 1, c'est la source du transistor NMOS du deuxième inverseur CMOS 119 qui est couplée au quatrième plot de contact 126. Dans cet exemple, la source du transistor PMOS du deuxième inverseur CMOS 119 est couplée à un potentiel électrique d'alimentation flottant 128. Enfin, le drain du deuxième transistor de puissance 106 est couplé à un autre plot de contact appelé deuxième plot de commutation 130.

Sur l'exemple de la figure 1, les composants du circuit 100 ne sont pas encore encapsulés. Le circuit 100 se trouve donc dans une configuration dans laquelle les connexions entre les plots 114 et 116, entre les plots 124 et 126, et entre les plots 120 et 130 ne sont pas encore réalisées, et donc dans une configuration dans laquelle des tests sous contrainte des grilles des transistors de puissance 102, 106 peuvent être mis en oeuvre. Dans cette configuration de test, les premier et deuxième plots de contact 114, 116 sont découplés l'un de l'autre. Ainsi, lors des tests sous contrainte des transistors de puissance, des potentiels électriques d'alimentation différents peuvent être appliqués sur chacun des premier et deuxième plots de contact 114, 116, ce qui permet d'appliquer sur le premier circuit de commande 104 une tension d'alimentation électrique plus faible que la tension de contrainte appliquée entre la grille et la source du premier transistor de puissance 102, et éviter ainsi une détérioration du premier circuit de commande 104 qui serait due à l'application de la tension de contrainte sur le premier circuit de commande 104.

Par exemple, lors d'un test sous contrainte du premier transistor de puissance 102, un premier potentiel électrique d'alimentation, par exemple égal à 11 V, peut être appliqué sur le premier plot de contact 114, et un deuxième potentiel électrique d'alimentation inférieur au premier potentiel électrique d'alimentation, par exemple égal à 5 V, peut être appliqué sur le deuxième plot de contact 116. Le potentiel électrique de la masse flottante 118 peut être égal à 0 V. Dans ce cas, en appliquant un potentiel électrique correspondant à un '1' logique en entrée de l'inverseur 110, par exemple égal à 5 V, le potentiel électrique obtenu en sortie du premier inverseur CMOS 109 et appliqué sur la grille du premier transistor de puissance 102 est nul. Un autre potentiel électrique d'alimentation égal au premier potentiel électrique peut être appliqué sur le premier plot de commutation 120 lors du test sous contrainte du premier transistor de puissance 102.

De même, dans cette configuration de test sous contrainte, les troisième et quatrième plots de contact 124, 126 sont découplés l'un de l'autre. Ainsi, lors des tests sous contrainte des transistors de puissance, des potentiels électriques de référence différents peuvent être appliqués sur chacun des troisième et quatrième plots de contact 124, 126, ce qui permet, comme pour les composants du côté haut du circuit 100, d'appliquer sur le deuxième circuit de commande 108 une tension d'alimentation électrique plus faible que la tension de contrainte appliquée entre la grille et la source du deuxième transistor de puissance 106.

Par exemple, lors d'un test sous contrainte du deuxième transistor de puissance 106, un premier potentiel électrique de référence égal à -6 V peut être appliqué sur le troisième plot de contact 124, et un deuxième potentiel électrique de référence supérieur au premier potentiel électrique de référence, par exemple égal à 0 V, peut être appliqué sur le quatrième plot de contact 126. Le potentiel électrique d'alimentation flottante 128 peut être égal à 5 V. Dans ce cas, en appliquant un potentiel électrique correspondant à un '1' logique en entrée de l'inverseur 122, par exemple égal à 5 V, le potentiel électrique obtenu en sortie du deuxième inverseur CMOS 119 et appliqué sur la grille du deuxième transistor de puissance 106 est égal à 5 V. Un autre potentiel électrique de référence égal au premier potentiel électrique de référence peut être appliqué sur le deuxième plot de commutation 130 lors du test sous contrainte du deuxième transistor de puissance 106.

Dans cette configuration de test telle que représentée sur la figure 1, les premier et deuxième plots de commutation 120, 130 sont découplés l'un de l'autre. Ainsi, il est possible de réaliser simultanément les tests sous contrainte des premier et deuxième transistors de puissance 102, 106.

Lors des tests sous contrainte des transistors de puissance 102, 106, un courant de fuite issu du premier transistor de puissance 102 peut être mesuré sur le premier plot de contact 114, et/ou un courant de fuite issu du deuxième transistor de puissance 106 peut être mesuré sur le troisième plot de contact 124. En variante, il est possible que le premier transistor de puissance 102 comporte une connexion de source Kelvin permettant la mesure d'un éventuel courant de fuite, avec dans ce cas la sortie du premier inverseur CMOS 109 mise dans une configuration haute-impédance lors du test sous contrainte de ce transistor, et/ou que le deuxième transistor de puissance 106 comporte une connexion de source Kelvin permettant la mesure d'un éventuel courant de fuite, avec dans ce cas la sortie du deuxième inverseur CMOS 119 mise dans une configuration haute-impédance lors du test sous contrainte de ce transistor.

La mise en oeuvre décrite ci-dessus des tests sous contrainte des grilles des transistors de puissance 102, 106 permet de mettre en évidence si l'un ou plusieurs de ces transistors de puissance 102, 106 présentent des défauts engendrant des courants de fuite. En présence de tels défauts, le circuit 100 est écarté et n'est pas utilisé. Grâce à la structure du circuit 100, les tests sous contraintes des transistors de puissance 102, 106 peuvent être mis en oeuvre sans soumettre les circuits de commande 104, 108 aux fortes tensions de contrainte utilisées lors de ces tests, les protégeant ainsi de ces tensions sans avoir à recourir à des composants additionnels dédiés à la protection des circuits de commande 104, 108. En outre, grâce au fait que les premier et deuxième plots de commutation 120, 130 ne sont pas couplés l'un à l'autre lors des tests sous contrainte des transistors de puissance 102, 106, ces transistors peuvent être testés en même temps au cours d'une même phase de test sous contrainte. De plus, avec cette configuration du circuit 100, il n'est pas nécessaire de prévoir des plots de contact dédiés uniquement à la mesure des éventuels courants de fuite et/ou à l'application des tensions de contrainte. Enfin, du fait de l'absence de composants électroniques dédiés à la protection des circuits de commande 104, 108, les performances du circuit 100, en particulier sa vitesse de fonctionnement, ne sont pas altérées par la présence de ces composants de protection.

Le circuit 100 est également adapté pour la mise en oeuvre de tests sous contrainte des drains des transistors de puissance 102 et 106. En outre, du fait de la déconnexion des plots de contact 114 et 116, 124 et 126, et 120 et 130 lorsque les composants du circuit 100 ne sont pas encore encapsulés, il est possible de mettre en oeuvre ces tests parallèlement sur les transistors de puissance 102 et 106.

Après la mise en oeuvre des tests sous contrainte des grilles des transistors de puissance 102, 106, les composants du circuit 100 sont encapsulés. Dans l'exemple de réalisation décrit ici, cette encapsulation est réalisée de manière à coupler entre eux :
- les premier et deuxième plots de contact 114, 116 ;
- les troisième et quatrième plots de contact 124, 126 ;
- les premier et deuxième plots de commutation 120, 130.

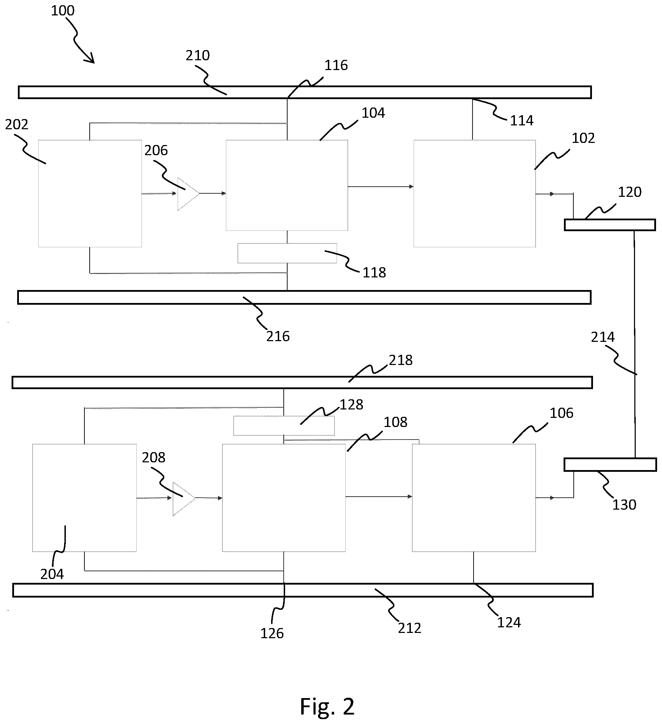

La figure 2 représente schématiquement les composants du circuit 100 après l'interconnexion des plots de contact 114, 116, 120, 124, 126 et 130 réalisée lors de l'encapsulation des composants du circuit 100. Outre les composants du circuit 100 précédemment décrits, le circuit 100 comporte également des composants analogiques et des composants logiques numériques désignés ensemble par la référence 202 pour le côté haut du circuit 100 et par la référence 204 pour le côté bas du circuit 100. Des signaux de sortie de ces composants sont envoyés en entrée des circuits de commande 104, 108 à travers des circuits convertisseur de niveau 206, 208, permettant notamment de commander les circuits de commande 104, 108. Ces composants sont également encapsulés.

L'encapsulation mise en oeuvre forme un premier connecteur électrique 210 couplant entre eux les premier et deuxième plots de contact 114, 116. L'encapsulation mise en oeuvre forme également un deuxième connecteur électrique 212 couplant entre eux les troisième et quatrième plots de contact 124, 126. Sur l'exemple de la figure 2, l'encapsulation forme également un troisième connecteur électrique 214 couplant entre eux les premier et deuxième plots de commutation 120, 130. En outre, dans l'exemple de réalisation décrit, l'encapsulation mise en oeuvre forme également un quatrième connecteur électrique 216 permettant l'application d'un potentiel électrique de référence sur le premier circuit de commande 104 (à travers la masse flottante 118) et sur les composants 202, ainsi qu'un cinquième connecteur électrique 218 permettant l'application d'un potentiel électrique d'alimentation sur le deuxième circuit de commande 108 (à travers l'alimentation flottante 118) et sur les composants 204.

Selon un exemple de réalisation, les connecteurs électriques 210 à 218 sont de type DCI (« Direct Copper Interconnection », ou interconnexion de cuivre directe), permettant d'avoir des connexions de faibles résistances électriques avec les plots 114, 116, 120, 124, 126 et 130. La réalisation de telles connexions entre les connecteurs électriques 210 à 218 et les plots 114 et 116, 124 et 126, et 120 et 130, peut être réalisée à l'échelle d'un panneau, ou PLP (« Panel Level Process » ou « Panel Level Packaging »).

En variante de l'exemple de réalisation décrit ci-dessus, les composants du côté haut et/ou du côté bas du circuit 100 pourraient être différents de ceux précédemment décrits.

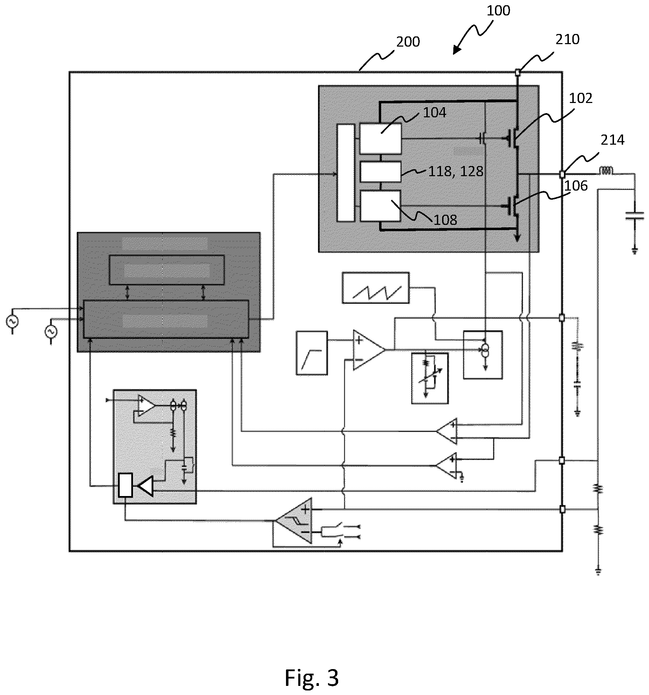

La figure 3 représente schématiquement un exemple de réalisation dans lequel le circuit électronique de puissance 100 correspond à un convertisseur DC-DC abaisseur de tension. Sur cette figure, un élément d'encapsulation 200 du circuit 100, par exemple un boîtier d'encapsulation ou tout autre moyen d'encapsulation adapté au circuit 100, est représenté symboliquement. Les différents composants autres que ceux précédemment décrits ne sont pas décrits en détails.

Le circuit électronique de puissance 100 peut s'appliquer en particulier au domaine automobile.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit électronique de puissance (100) comprenant au moins un transistor de puissance (102, 106) dont la grille est couplée à un circuit de commande (104, 108) et dont la source est couplée à un premier plot de contact (114, 124), dans lequel le circuit de commande (104, 108) est couplé à un deuxième plot de contact (116, 126), et dans lequel les premier et deuxième plots de contact (114, 116, 124, 126) sont configurés pour être découplés l'un de l'autre lorsque le circuit électronique de puissance (100) est dans une configuration de test sous contrainte de la grille du transistor de puissance (102, 106) et configurés pour être couplés l'un à l'autre lorsque le transistor de puissance (102, 106) et le circuit de commande (104, 108) sont encapsulés.

2. Circuit électronique de puissance (100) selon la revendication 1, dans lequel le transistor de puissance (102) et le circuit de commande (104) sont des composants côté haut du circuit électronique de puissance (100), et dans lequel les premier et deuxième plots de contact (114, 116) sont configurés pour que des potentiels électriques d'alimentation différents soient appliqués sur chacun d'eux lorsque le circuit électronique de puissance (100) est dans la configuration de test sous contrainte de la grille du transistor de puissance (102).

3. Circuit électronique de puissance (100) selon la revendication 1, dans lequel le transistor de puissance (106) et le circuit de commande (108) sont des composants côté bas du circuit électronique de puissance (100), et dans lequel les premier et deuxième plots de contact (124, 126) sont configurés pour que des potentiels électriques de référence différents soient appliqués sur chacun d'eux lorsque le circuit électronique de puissance (100) est dans la configuration de test sous contrainte de la grille du transistor de puissance (106).

4. Circuit électronique de puissance (100) selon la revendication 1, dans lequel :
- le transistor de puissance (102), appelé premier transistor de puissance, et le circuit de commande (104), appelé premier circuit de commande, sont des composants côté haut du circuit électronique de puissance (100), et
- le circuit électronique de puissance (100) comporte en outre un deuxième transistor de puissance (106) dont la grille est couplée à un deuxième circuit de commande (108) et dont la source est couplée à un troisième plot de contact (124), le deuxième circuit de commande (108) étant couplé à un quatrième plot de contact (126), le deuxième transistor de puissance (106) et le deuxième circuit de commande (108) correspondant à des composants côté bas du circuit électronique de puissance (100), et
- les premier et deuxième plots de contact (114, 116) sont configurés pour que des potentiels électriques d'alimentation différents soient appliqués sur chacun d'eux lorsque le circuit électronique de puissance (100) est dans une configuration de test sous contrainte des grilles des premier et deuxième transistors de puissance (102, 106), et
- les troisième et quatrième plots de contact (124, 126) sont configurés pour être découplés l'un de l'autre et pour que des potentiels électriques de référence différents soient appliqués sur chacun d'eux lorsque le circuit électronique de puissance (100) est dans la configuration de test sous contrainte des grilles des premier et deuxième transistors de puissance (102, 106), et configurés pour être couplés l'un à l'autre lorsque les premier et deuxième transistors de puissance (102, 106) et les premier et deuxième circuits de commande (104, 108) sont encapsulés.

5. Circuit électronique de puissance (100) selon la revendication 4, dans lequel le drain du premier transistor de puissance (102) est couplé à un premier plot de commutation (120) et le drain du deuxième transistor de puissance (106) est couplé à un deuxième plot de commutation (130), et dans lequel les premier et deuxième plots de commutation (120, 130) sont configurés pour être découplés l'un de l'autre lorsque le circuit électronique de puissance (100) est dans la configuration de test sous contrainte des grilles des premier et deuxième transistors de puissance (102, 106) et configurés pour être couplés l'un à l'autre lorsque les premier et deuxième transistors de puissance (102, 106) et les premier et deuxième circuits de commande (104, 108) sont encapsulés.

6. Circuit électronique de puissance (100) selon l'une quelconque des revendications précédentes, dans lequel le circuit de commande (104, 108), ou chacun des premier et deuxième circuits de commande (104, 108), comporte un inverseur CMOS (109, 119) dont la sortie est couplée à la grille du transistor de puissance (102, 106) ou d'un des premier et deuxième transistors de puissance (102, 106), et/ou dans lequel le transistor de puissance (102, 106), ou chacun des premier et deuxième transistors de puissance (102, 106), correspond à un MOSFET.

7. Circuit électronique de puissance (100) selon l'une quelconque des revendications précédentes, incluant un élément d'encapsulation (200).

8. Circuit électronique de puissance (100) selon la revendication 7, comportant en outre un premier connecteur électrique (210) couplant électriquement entre eux les premier et deuxième plots de contact (114, 116), et, lorsque le circuit électronique de puissance (100) comporte des troisième et quatrième plots de contact (124, 126), un deuxième connecteur électrique (212) couplant entre eux les troisième et quatrième plots de contact (124, 126).

9. Circuit électronique de puissance (100) selon la revendication 8, comportant les premier et deuxième plots de commutation (120, 130) et un troisième connecteur électrique (214) couplant entre eux les premier et deuxième plots de commutation (120, 130).

10. Circuit électronique de puissance (100) selon la revendication 9, correspondant à un convertisseur DC-DC.

11. Procédé de réalisation et d'encapsulation d'au moins un circuit électronique de puissance (100), comportant au moins les étapes suivantes :
- réalisation du circuit électronique de puissance (100) selon l'une quelconque des revendications 1 à 6 ;
- mise en oeuvre d'un test sous contrainte de la ou des grilles du ou des transistors de puissance (102, 106) du circuit électronique de puissance (100) ;
- encapsulation du ou des transistors de puissance (102, 106) et du ou des circuits de commande (104, 108) du circuit électronique de puissance (100).

12. Procédé selon la revendication 11, dans lequel le test sous contrainte de la ou des grilles du ou des transistors de puissance (102, 106) comporte une mesure d'un courant de fuite sur le premier plot de contact (114) et/ou sur le troisième plot de contact (124).

13. Procédé selon l'une quelconque des revendications 11 ou 12, dans lequel l'encapsulation du ou des transistors de puissance (102, 106) et du ou des circuits de commande (104, 108) comporte une réalisation d'un premier connecteur électrique (210) couplant électriquement entre eux les premier et deuxième plots de contact (114, 116) du circuit électronique de puissance (100), et, lorsque le circuit électronique de puissance (100) comporte des troisième et quatrième plots de contact (124, 126), une réalisation d'un deuxième connecteur électrique (212) couplant entre eux les troisième et quatrième plots de contact (124, 126) du circuit électronique de puissance (100).

14. Procédé selon la revendication 13, dans lequel l'encapsulation du ou des transistors de puissance (102, 106) et du ou des circuits de commande (104, 108) comporte en outre une réalisation d'un troisième connecteur électrique (214) couplant entre eux les premier et deuxième plots de commutation (120, 130) du circuit électronique de puissance (100).
